# EUROPEAN PATENT APPLICATION

(11) **EP 2 361 005 A1**
(43) Date of publication of application: **24.08.2011**
(21) Application number: 09831829.8
(22) Date of filing: 30.11.2009
(51) Int. Cl.: H05K 7/20, H01L 23/36, H05K 9/00

(54) **CIRCUIT MODULE**

(30) Priority: 12.12.2008 JP 2008317102
(71) Applicant: Murata Manufacturing Co. Ltd., Kyoto 617-8555 (JP)
(72) Inventor: HARA Koichi, Nagaokakyo-shi Kyoto 617-8555 (JP)
(74) Representative: Zimmermann, Tankred Klaus
(86) International application number: PCT/JP2009/070116
(87) International publication number: WO 2010/067725

(57) **Abstract**

A plurality of electronic components 1 and 2 including at least one heat-generating electronic component 1 and constituting an electronic circuit are spaced from each other on a circuit board 4. Regions of one or both sides of the circuit board 4, including regions around the plurality of electronic components 1 and 2, are covered with a heat-dissipating member 3. A surface of the heat-dissipating member 3 facing the circuit board 4 has irregularities. An end surface of a protrusion 5 in the facing surface of the heat-dissipating member 3 is in contact with a circuit board surface between the electronic components 1 and 2, directly or with a heat-dissipating sheet 7 interposed therebetween. A wall surface of a recess 6 in the facing surface of the heat-dissipating member 3 is in surface-contact with the heat-generating electronic component 1 within the recess 6, directly or with the heat-dissipating sheet 7 interposed therebetween. Thus, heat from the heat-generating electronic component 1 and heat from the circuit board 4 heated by the heat from the heat-generating electronic component 1 are dissipated outside through the heat-dissipating member 3.

## Description

### Technical Field

The present invention relates to a circuit module that includes a circuit board having a plurality of electronic components, including a heat-generating electronic component, thereon and is used in electric devices.

### Background Art

In recent years, there has been growing demand for small and low-profile electric devices. In response to this, electronic components constituting an electric circuit are densely mounted on a circuit board. Of a variety of such electronic components, various ICs such as an RF IC and a base band (BB) IC, an amplifier, a DC converter, and a RAM are known to generate a large amount of heat when a current is applied thereto. In particular, a higher-frequency IC generates a larger amount of heat. Therefore, if the electronic components described above are densely mounted, such an IC may have an adverse impact on its neighboring electronic components. In the invention of the present application, an electronic component, such as any of the various ICs described above, that generates a large amount of heat by applying a current thereto and is heated by heat generation to a temperature exceeding a temperature range within which operation is guaranteed, is referred to as a heat-generating electronic component.

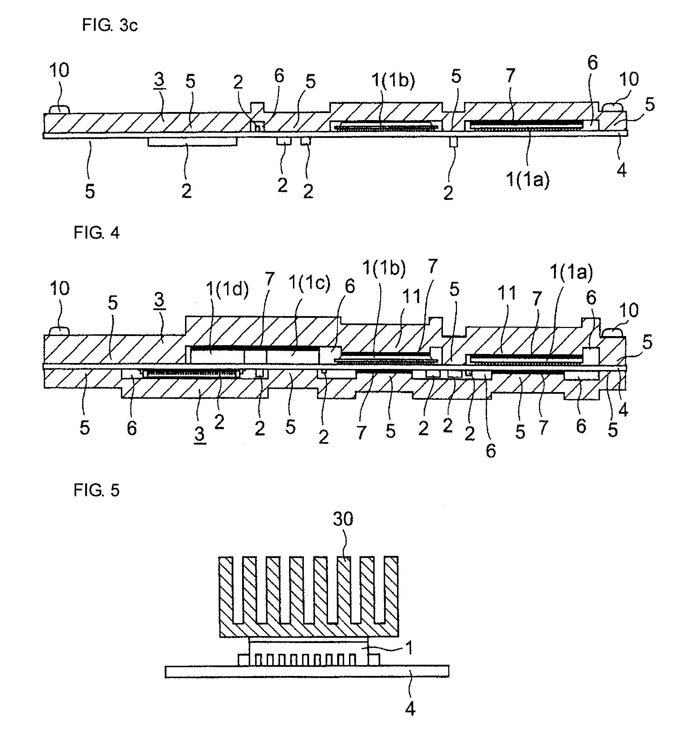

Fig. 5 is a schematic cross-sectional view illustrating a structure for dissipating heat from a heat-generating electronic component according to the related art (see, e.g., Patent Document 1). As illustrated in Fig. 5, in this example, a heat sink 30 is disposed on the upper side of a heat-generating electronic component 1 mounted on a circuit board 4. The heat sink 30 provides a structure that dissipates heat from the heat-generating electronic component 1. The heat-generating electronic component 1 of this type is typically contained in a package of metal plates etc., integrated into a module, and used in the form of a circuit module.

Patent Document 1: Japanese Unexamined Patent Application Publication No. 2001-257489

### Disclosure of Invention

### Problems to be Solved by the Invention

However, with the heat-dissipating structure illustrated in Fig. 5 where heat from the heat-generating electronic component 1 is dissipated only from the upper side of the heat-generating electronic component 1, it is difficult to sufficiently dissipate heat from the heat-generating electronic component 1. Moreover, since the heat sink 30 is bulky, it is difficult to realize a small and low-profile circuit module. Additionally, providing the heat sink 30 for each heat-generating electronic component 1 will result in a cost increase. As for the heat-generating electronic component 1 to which it is difficult to attach the heat sink 30, heat from the heat-generating electronic component 1 cannot be dissipated by the heat sink 30.

### Means for Solving the Problems

To solve the problems described above, the present invention is configured as follows. That is, as a means to solve the problems described above, the present invention has a configuration which includes a plurality of electronic components including at least one heat-generating electronic component, the plurality of electronic components constitute an electronic circuit, and are spaced from each other on one or both sides of a circuit board; and a heat-dissipating member covering regions of a circuit board surface from one or both sides of the regions, the regions including at least regions around the plurality of electronic components including the heat-generating electronic component and one or more electronic components other than the heat-generating electronic component, wherein a surface of the heat-dissipating member facing the circuit board has irregularities; an end surface of a protrusion in the facing surface of the heat-dissipating member is in contact with the circuit board surface between the electronic components, directly or with a heat-dissipation mediating member interposed therebetween; a wall surface of a recess in the facing surface of the heat-dissipating member is in surface-contact with the heat-generating electronic component within the recess, directly or with the heat-dissipation mediating member interposed therebetween, so that heat from the heat-generating electronic component and heat from the circuit board heated by the heat from the heat-generating electronic component are dissipated outside through the heat-dissipating member.

### Advantages

In a circuit module according to the present invention, regions of a circuit board surface, including regions around a plurality of electronic components disposed on one or both sides of a circuit board, are covered with a heat-dissipating member from one or both sides. A surface of the heat-dissipating member facing the circuit board has irregularities, and an end surface of a protrusion in the facing surface of the heat-dissipating member is in contact with the circuit board surface between the electronic components, directly or with a heat-dissipation mediating member interposed therebetween. The electronic components include at least one heat-generating electronic component.
A wall surface of a recess in the facing surface of the heat-dissipating member is in surface-contact with the heat-generating electronic component within the recess, directly or with the heat-dissipation mediating member interposed therebetween.

In the present invention, where the heat-dissipating member is provided as described above, heat from the heat-generating electronic component and heat from the circuit board heated by the heat from the heat-generating electronic component are dissipated outside through the heat-dissipating member. Therefore, in the present invention, unlike the related art in which a heat sink is provided on the upper side of a heat-generating electronic component for heat dissipation, heat from the heat-generating electronic component can be dissipated sufficiently. Specifically, in the present invention, heat from the heat-generating electronic component is dissipated outside through the heat-dissipating member and, at the same time, heat from the circuit board heated by the heat from the heat-generating electronic component is dissipated through the heat-dissipating member. The present invention thus makes it possible to improve heat dissipation efficiency, realize uniform distribution of heat throughout the circuit board, and prevent the circuit board from being heated to high temperatures by heat from the heat-generating electronic component. Therefore, in the present invention, it is possible to reduce adverse impact of heat on electronic components around the heat-generating electronic component, improve reliability of the circuit module, and achieve greater longevity of the circuit module.

The present invention is configured such that an end surface of a protrusion in the facing surface of the heat-dissipating member is in contact with the circuit board, and a wall surface of a recess in the facing surface of the heat-dissipating member is in contact with the heat-generating electronic component. Therefore, a space between the heat-dissipating member and the circuit board and between the heat-dissipating member and the heat-generating electronic component can be made smaller than a space between the package and the circuit board and between the package and the heat-generating electronic component in the circuit module of the related art. Heat from the heat-generating electronic component and heat from the circuit board can thus be very efficiently dissipated through the heat-dissipating member.

Also in the present invention, where the circuit board is covered with the heat-dissipating member and one or more electronic components on the circuit board are contained within the recess, the heat-dissipating member can also serve as a housing for the circuit module. Therefore, unlike the configuration in which a heat-dissipating structure, including a heat-generating electronic component and a heat sink on the upper side of the heat-generating electronic component, is contained in a housing, the circuit module of the present invention is not bulky and it is possible to realize a small, low-profile, and low-cost product.

In a preferred embodiment of the present invention, the heat-dissipating member covers at least a region in a circuit board surface on a back side of the circuit board surface where the heat-generating electronic component is disposed, the region corresponding to a region where the heat-generating electronic component is disposed. The heat-dissipating member is in contact with the circuit board surface on the back side, directly or with the heat-dissipation mediating member interposed therebetween. With this configuration, heat from the heat-generating electronic component can be dissipated also from the circuit board surface on the back side of the circuit board surface where the heat-generating electronic component is disposed, through the heat-dissipating member. It is thus possible to further improve heat dissipation efficiency.

In another preferred embodiment of the present invention, the circuit board is provided with a through hole in an area where the heat-generating electronic component is provided. The protrusion of the heat-dissipating member which covers the circuit board surface on the back side of the region where the heat-generating electronic component is disposed is in contact with the heat-generating electronic component through the through hole, directly or with the heat-dissipation mediating member interposed therebetween. With this configuration, heat from the heat-generating electronic component can be dissipated also from the circuit board surface where the heat-generating electronic component is disposed, through the heat-dissipating member to the outside. It is thus possible to further improve heat dissipation efficiency.

In another preferred embodiment of the present invention, the heat-dissipating member has irregularities also in an outer wall surface thereof. With this configuration, since it is possible to increase the surface area of the outer wall surface of the heat-dissipating member and increase the surface in contact with the outside, heat dissipation efficiency can be further improved.

In another preferred embodiment of the present invention, the heat-dissipating member is made of conductive material, electrically connected at least partially to a ground area of the circuit board, and configured to serve also as a shielding member for shielding the electric circuit. With this configuration, where there is no need to provide an additional shielding member for shielding the electric circuit, it is possible to reduce the number of components and limit the associated cost increase.

A resist film formed on a circuit board surface is known to have low thermal conductivity. In another preferred embodiment of the present invention, the protrusion of the heat-dissipating member faces the circuit board in a resist gap where no resist film is present, and the protrusion of the heat-dissipating member is in contact with the resist gap. With this configuration, where the end surface of the protrusion of the heat-dissipating member is in contact with a highly thermally-conductive region of the circuit board in the resist gap, it is possible to efficiently transfer heat from the circuit board surface to the heat-dissipating member, and to further improve heat dissipation efficiency.

The present invention includes a configuration in which a plurality of protrusions are formed in the facing surface of the heat-dissipating member. In this case, the above-described configuration in which the protrusion of the heat-dissipating member is in contact with the resist gap can be realized if at least one of the plurality of protrusions is in contact with the resist gap. Again, this makes it possible to improve heat dissipation efficiency.

A ground area formed on the circuit board surface has thermal conductivity higher than that of a non-ground area. Therefore, in the present invention, with the above-described configuration in which the protrusion of the heat-dissipating member is in contact with the ground area, it is possible to efficiently transfer heat from the circuit board surface through the heat-dissipating member and thus to further improve heat dissipation efficiency.

The present invention includes a configuration in which a plurality of protrusions are formed in the facing surface of the heat-dissipating member. In this case, the above-described configuration in which the protrusion of the heat-dissipating member is in contact with the ground area can be realized if at least one of the plurality of protrusions is in contact with the ground area. Again, this makes it possible to improve heat dissipation efficiency.

### Brief Description of Drawings

[Fig. 1] Fig. 1 is a schematic cross-sectional view for explaining a circuit module of a first embodiment.
[Fig. 2] Fig. 2 is a schematic cross-sectional view for explaining a circuit module of a second embodiment.
[Fig. 3a] Fig. 3a is a schematic cross-sectional view for explaining a circuit module of another embodiment.
[Fig. 3b] Fig. 3b is a schematic cross-sectional view for explaining a circuit module of another embodiment.
[Fig. 3c] Fig. 3c is a schematic cross-sectional view for explaining a circuit module of another embodiment.
[Fig. 4] Fig. 4 is a schematic cross-sectional view for explaining a circuit module of another embodiment.
[Fig. 5] Fig. 5 is a schematic cross-sectional view for explaining a structure for dissipating heat from a heat-generating electronic component according to the related art.

1, 1a to 1d: heat-generating electronic component
2: non-heat-generating electronic component
3: heat-dissipating member
4: circuit board
5: protrusion
6: recess
7: heat-dissipating sheet
8: through hole
11: in-recess protrusion

### Best Modes for Carrying Out the Invention

Embodiments of the present invention will now be described with reference to the drawings. In the description of the present embodiment, an explanation about elements similar to those in the related art will be omitted or simplified.

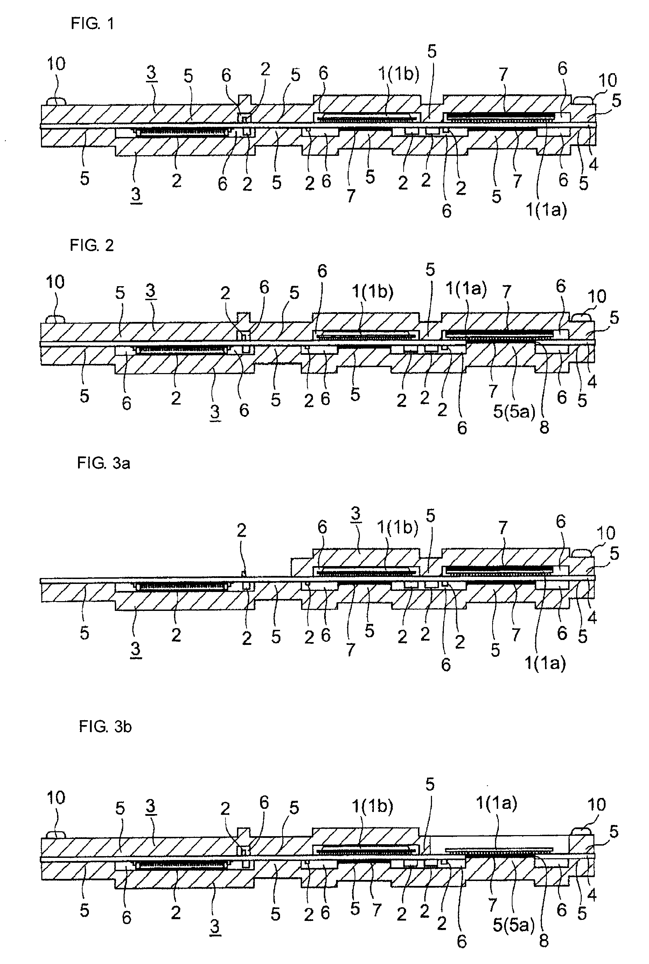

Fig. 1 is a schematic cross-sectional view illustrating a circuit module according to a first embodiment of the present invention. As illustrated in Fig. 1, the circuit module of the present embodiment includes a circuit board 4. A plurality of electronic components 1 and 2 including one or more (two in this case) heat-generating electronic components 1 (1a and 1b) and constituting an electric circuit, such as a power supply circuit or a communication circuit, are spaced from each other on both sides of the circuit board 4. Electronic components denoted by reference numeral 2 are non-heat-generating electronic components, which are not the heat-generating electronic components 1. Specifically, the non-heat-generating electronic components are electronic components whose temperatures are within a temperature range in which operation is guaranteed even when they generate heat when a current is applied thereto (i.e., electronic components which generate a small amount of heat). Ground areas are formed on both sides of the circuit board 4, and a resist film (not shown) is formed in appropriate regions of the circuit board 4.

In the present embodiment, the circuit board 4 is entirely covered with a heat-dissipating member 3 from both sides. The heat-dissipating member 3 is of stamped metal, such as aluminum, which is a conductive metal having good thermal conductivity. The heat-dissipating member 3 is soldered to the circuit board 4, with lands (not shown) interposed therebetween. At the same time, the heat-dissipating member 3 is secured to the circuit board 4 with screws 10 at both left and right ends thereof in the drawing.

The heat-dissipating member 3 and the circuit board 4 each are provided with taps (not shown) at both ends. The screws 10 are screwed into the taps. Areas where heads of the screws 10 are in contact with the circuit board are resist gaps where the resist film is absent. Instead of the taps described above, there may be through holes for insertion of the screws.

A surface of the heat-dissipating member 3 facing the circuit board 4 has irregularities. An end surface of a protrusion 5 in the facing surface of the heat-dissipating member 3 is in contact with a ground area (ground electrode) of the circuit board 4 between the electronic components 1 and 2, directly or with a heat-dissipating sheet 7 serving as a heat-dissipation mediating member interposed therebetween. An end surface of another protrusion 5 is in contact with a ground area in a region of the circuit board 4 where the electronic components 1 and 2 are not provided, directly or with the heat-dissipating sheet 7 interposed therebetween. In the present embodiment, the heat-dissipating member 3 having conductivity is directly in contact with ground areas at some points. Therefore, the heat-dissipating member 3 is electrically connected to the ground areas and serves also as a shielding member for shielding the electric circuit. The heat-dissipating sheet 7 is resistant to heat-generating temperatures of the heat-generating electronic components 1.

The facing surface of the heat-dissipating member 3 has a plurality of protrusions 5. At least one of the plurality of protrusions 5 faces and is in contact with a resist gap of the circuit board 4.

A wall surface of a recess 6 in the facing surface of the heat-dissipating member 3 is in surface-contact with the heat-generating electronic component 1 within the recess 6, directly or with the heat-dissipating sheet 7 interposed therebetween. In this example, the wall surface of the recess 6 which contains the heat-generating electronic component 1a is in surface-contact with the heat-generating electronic component 1a with the heat-dissipating sheet 7 interposed therebetween. On the other hand, the wall surface of the recess 6 which contains the heat-generating electronic component 1b is directly in surface-contact with the heat-generating electronic component 1b.

The heat-dissipating member 3 is configured also to cover a circuit board surface on the back side of the regions where the heat-generating electronic components 1a and 1b are disposed. In this circuit board surface (i.e., the circuit board surface on the back side of the heat-generating electronic components 1a and 1b), regions corresponding to the regions where the heat-generating electronic components 1a and 1b are disposed are in contact with the heat-dissipating member 3, with the heat-dissipating sheet 7 interposed therebetween.

In the present embodiment, as described above, the protrusions 5 in the facing surface of the heat-dissipating member 3 are in contact with the circuit board surface, and the recesses 6 in the facing surface of the heat-dissipating member 3 are in surface-contact with the heat-generating electronic components 1 (1a and 1b). Thus, in the present embodiment, heat from the heat-generating electronic components 1a and 1b and heat from the circuit board 4 heated by the heat from the heat-generating electronic components 1a and 1b are dissipated outside through the heat-dissipating member 3. In the present embodiment, through this heat dissipation, heat from the heat-generating electronic components 1 can be directly dissipated to the outside, and heat from the circuit board 4 heated by the heat from the heat-generating electronic components can be dissipated. Therefore, in the present embodiment, it is possible to improve heat dissipation efficiency, and reduce adverse impact of heat on electronic components around the heat-generating electronic components. Additionally, an outer wall surface of the heat-dissipating member 3 has irregularities formed by stamping. This increases the surface area of the outer wall surface and improves heat dissipation efficiency.

Also, in the present embodiment, the circuit board 4 is entirely covered with the heat-dissipating member 3, which is in surface-contact with the circuit board 4 in most of the regions where the electronic components 1 and 2 are not provided. Thus, the present embodiment can improve thermal connection between the heat-dissipating member 3 and the circuit board 4, and can improve heat dissipation efficiency.

In the present embodiment, the heat-dissipating member 3 serves both as a housing that protects the electric circuit of the circuit module, and as a shielding case that shields the electric circuit. In the circuit module of the related art, a space between the package and the circuit board is entirely filled with air. In contrast, in the present embodiment, a space between the heat-dissipating member 3 and the circuit board 4 is limited only to a small space between the recesses 6 and the electronic components 1 and 2. Thus, since there is little air within the circuit module, it is possible again to improve heat dissipation efficiency.

Fig. 2 is a schematic cross-sectional view illustrating a circuit module according to a second embodiment of the present invention. In Fig. 2, the same elements as those of the first embodiment illustrated in Fig. 1 are given the same reference numerals. In the description of the second embodiment, an explanation overlapping with the first embodiment will be omitted or simplified.

In the circuit module of the second embodiment, the circuit board 4 is provided with a through hole 8 in an area where the heat-generating electronic component 1a is provided. At the same time, a protrusion 5 (5a) of the heat-dissipating member 3 which covers the circuit board surface on the back side of the region where the heat-generating electronic component 1a is provided is in contact with the heat-generating electronic component 1a through the through hole 8, with the heat-dissipating sheet 7 interposed therebetween. The other configurations of the second embodiment are the same as those of the first embodiment.

The present invention is not limited to the first and second embodiments described above, and can be embodied in various forms. For example, although the heat-dissipating member is made of metal, such as aluminum, in the embodiments described above, the heat-dissipating member 3 may be made of conductive material, such as conductive resin, obtained by mixing metal powder etc. When the heat-dissipating member 3 is not required to serve also as a shielding member, the heat-dissipating member 3 may be made of non-conductive material. Note than when the heat-dissipating member 3 is configured to be directly in contact with the heat-generating electronic components 1, the heat-dissipating member 3 is made of heat-resistant material which is resistant to heat generated by the heat-generating electronic components 1.

Although the heat-dissipating member 3 is formed by stamping in the embodiments described above, the heat-dissipating member 3 may be formed by metal cutting or other processing methods. When the heat-dissipating member 3 is made of resin, the heat-dissipating member 3 may be formed by resin molding. A processing method for the heat-dissipating member 3 is thus appropriately set.

Although the outer wall surface of the heat-dissipating member 3 has irregularities in the embodiments described above, the outer wall surface of the heat-dissipating member 3 may be a flat surface with no irregularities.

In the embodiments described above, the circuit board 4 is entirely covered with the heat-dissipating member 3 from both sides. However, for example, as illustrated in Fig. 3a and Fig. 3b, the circuit board 4 may be partially covered with the heat-dissipating member 3. Alternatively, for example, as illustrated in Fig. 3c, only one side of the circuit board 4 may be covered with the heat-dissipating member 3.

Fig. 3a illustrates an example where the heat-dissipating member 3 which covers the front side of the circuit board 4 (i.e., the circuit board surface on the upper side in the drawing) is provided only in regions around the heat-generating electronic components 1. Fig. 3c illustrates an example where the heat-dissipating member 3 is provided only on one side of the circuit board 4, and only the circuit board surface on the upper side in the drawing is covered with the heat-dissipating member 3. Alternatively, only the circuit board surface on the lower side in the drawing may be covered with the heat-dissipating member 3, depending on the arrangement of the heat-generating electronic components 1.

Fig. 3b illustrates an example where the heat-generating electronic component 1a is an antenna composite IC, and the heat-dissipating member 3 is partially removed on the upper side of the heat-generating electronic component 1a. The antenna composite IC is an IC having an antenna structure in the upper surface thereof. Therefore, if the heat-generating electronic component 1a has an antenna structure in the front surface thereof, such as in the case of the antenna composite IC, and is shielded on the upper side, the antenna function may be impaired.

Thus, in the example of Fig. 3b, the heat-dissipating member 3 is not provided on the upper side of the heat-generating electronic component 1a. However, in the example of Fig. 3b, the heat-dissipating member 3 covering the back side of the heat-generating electronic component 1a is in contact with the heat-generating electronic component 1a through the through hole 8. Heat from the heat-generating electronic component 1a is thus dissipated from the mounting surface of the circuit board 4.

If the heat-generating electronic components 1 are antenna composite ICs, and the heat-dissipating member 3 is in contact with the upper surfaces of the heat-generating electronic components 1 as in the cases of the embodiments described above, it is possible to use the following configurations. That is, parts of the heat-dissipating member 3 in contact with the upper surfaces of the heat-generating electronic components 1 may be made of non-metal material having no shielding effect, or may be provided with openings for passage of radio waves. These configurations can be used as necessary, regardless of whether the heat-generating electronic components 1 are antenna composite ICs.

As illustrated in Fig. 4, if one recess 6 of the heat-dissipating member 3 contains a plurality of heat-generating electronic components 1, the wall surface of the recess 6 may be provided with stepped portions corresponding to the respective heights of the heat-generating electronic components 1. In this example, the recess 6 on the left of the drawing contains a plurality of heat-generating electronic components 1b, 1c, and 1d. The recess 6 is internally provided with an in-recess protrusion 11 that protrudes toward the heat-generating electronic components 1. The wall surface of the in-recess protrusion 11 is in surface-contact with the heat-generating electronic component 1b, directly or with a heat-dissipation mediating member such as the heat-dissipating sheet 7 (the heat-dissipating sheet 7 in this case) interposed therebetween. The in-recess protrusion 11 may be provided in the recess 6 which contains one heat-generating electronic component 1.
In the example of Fig. 4, the recess 6 which contains the heat-generating electronic component 1a is also provided with the in-recess protrusion 11. The wall surface of this in-recess protrusion 11 is in surface-contact with the heat-generating electronic component 1a with the heat-dissipating sheet 7 interposed therebetween.

In the embodiments described above, the heat-dissipating sheet 7 has been described as an example of the heat-dissipation mediating member provided on the contact surface between the heat-dissipating member 3 and the heat-generating electronic components 1. Examples of the heat-dissipation mediating member, other than the heat-dissipating sheet 7, may include thermally conductive grease.

In the embodiments described above, an area of the circuit board 4 in contact with at least one of the plurality of protrusions 5 in the facing surface of the heat-dissipating member 3 is a resist gap. However, the end surfaces of all the protrusions 5 in the facing surface of the heat-dissipating member 3 may be in contact with the areas where a resist film is provided. That is, even when a resist film is provided, if the resist film is not thick enough to significantly interfere with the heat dissipation efficiency, the protrusions 5 of the heat-dissipating member 3 may be in contact with the region where the resist film is provided.

In the embodiments described above, the end surfaces of the protrusions 5 in the facing surface of the heat-dissipating member 3 are in contact with ground areas of the circuit board 4. Alternatively, the end surfaces of the protrusions 5 may be in contact with non-ground areas of the circuit board 4. In general, however, ground areas made of metal have better thermal conductivity than non-ground areas made of resin or the like. Therefore, if the end surfaces of the protrusions 5 of the heat-dissipating member 3 are in contact with the ground areas of the circuit board 4, it is possible to achieve higher heat dissipation efficiency than that in the case where the end surfaces of the protrusions 5 of the heat-dissipating member 3 are in contact with the non-ground areas of the circuit board 4.

When the end surfaces of the protrusions 5 in the facing surface of the heat-dissipating member 3 are in contact with the ground areas of the circuit board 4, if the heat-dissipating member 3 is made of conductive material, the heat-dissipating member 3 can serve also as a shielding member. If the end surfaces of the protrusions 5 in the facing surface of the heat-dissipating member 3 are in contact with the non-ground areas of the circuit board 4, at least part of the heat-dissipating member 3 may be electrically connected to the ground areas (e.g., with lands etc. interposed therebetween) to enable the heat-dissipating member 3 to have a shielding effect.

In the embodiments described above, the heat-dissipating member 3 is secured to the circuit board 4 by both screwing and soldering. However, the dissipating member 3 may be secured to the circuit board 4 by one of screwing and soldering. Alternatively, the heat-dissipating member 3 may be secured to the circuit board 4 with an adhesive, depending on the material of the heat-dissipating member 3.

### Industrial Applicability

According to the present invention, it is possible to efficiently dissipate heat from heat-generating electronic components, realize a small and low-profile circuit module, and limit cost increases. Thus, the present invention is applicable to a circuit module used in electric devices which include electronic components, such as heat-generating electronic components.

## Claims

1. A circuit module comprising a plurality of electronic components including at least one heat-generating electronic component, the plurality of electronic components constitute an electronic circuit, and are spaced from each other on one or both sides of a circuit board; and a heat-dissipating member covering regions of a circuit board surface from one or both sides of the regions, the regions including at least regions around the plurality of electronic components including the heat-generating electronic component and one or more electronic components other than the heat-generating electronic component,
wherein a surface of the heat-dissipating member facing the circuit board has irregularities; an end surface of a protrusion in the facing surface of the heat-dissipating member is in contact with the circuit board surface between the electronic components, directly or with a heat-dissipation mediating member interposed therebetween; a wall surface of a recess in the facing surface of the heat-dissipating member is in surface-contact with the heat-generating electronic component within the recess, directly or with the heat-dissipation mediating member interposed therebetween, so that heat from the heat-generating electronic component and heat from the circuit board heated by the heat from the heat-generating electronic component are dissipated outside through the heat-dissipating member.

2. The circuit module according to Claim 1, wherein the heat-dissipating member covers at least a region in a circuit board surface on a back side of the circuit board surface where the heat-generating electronic component is disposed, the region corresponding to a region where the heat-generating electronic component is disposed, and the heat-dissipating member is in contact with the circuit board surface on the back side, directly or with the heat-dissipation mediating member interposed therebetween.

3. The circuit module according to Claim 1, wherein the circuit board is provided with a through hole in an area where the heat-generating electronic component is provided; and
the heat-dissipating member covers at least the circuit board surface on the back side of the region where the heat-generating electronic component is disposed, and the protrusion of the heat-dissipating member is in contact with the heat-generating electronic component through the through hole, directly or with the heat-dissipation mediating member interposed therebetween.

4. The circuit module according to any one of Claims 1 to 3, wherein the heat-dissipating member has irregularities also in an outer wall surface thereof.

5. The circuit module according to any one of Claims 1 to 3, wherein the heat-dissipating member is made of conductive material, electrically connected at least partially to a ground area of the circuit board, and configured to serve also as a shielding member for shielding the electric circuit.

6. The circuit module according to any one of Claims 1 to 3, wherein the circuit board surface covered with the heat-dissipating member is provided with a resist film, a resist gap where the resist film is absent is provided at a position facing the protrusion of the heat-dissipating member, and the protrusion of the heat-dissipating member is in contact with the circuit board surface in the resist gap.

7. The circuit module according to any one of Claims 1 to 3, wherein the circuit board surface has a ground area, and the protrusion of the heat-dissipating member is in contact with the ground area.
